## Europäisches Patentamt

## European Patent Office

## Office européen des brevets

(19)

(11) Veröffentlichungsnummer: **0 022 931**
**B1**

(12)

# EUROPÄISCHE PATENTSCHRIFT

(45) Veröffentlichungstag der Patentschrift:
06.07.83

(51) Int. Cl.³: **H 03 K 19/094,** H 03 K 5/00

(21) Anmeldenummer: **80103391.1**

(22) Anmeldetag: **18.06.80**

(54) Schaltungsanordnung zur Spannungspegelumsetzung und zugehöriges Verfahren.

(30) Priorität: **20.07.79 DE 2929383**

(43) Veröffentlichungstag der Anmeldung:
**28.01.81 Patentblatt 81/4**

(45) Bekanntmachung des Hinweises auf die Patenterteilung:
**06.07.83 Patentblatt 83/27**

(84) Benannte Vertragsstaaten:
**DE FR GB NL SE**

(56) Entgegenhaltungen:
**DE-A-2 243 671**
**US-A-3 708 689**
**US-A-3 710 271**
**US-A-4 023 050**
**IEEE JOURNAL OF SOLID-STATE CIRCUITS,**
**Band SC-13, Nr. 3, Juni 1978 New York E. ARAI et**
**al. »A 64-kbit Dynamic MOS RAM« Seiten 333 bis**
**338**

(73) Patentinhaber: **International Business Machines Corporation, Armonk, N.Y. 10504 (US)**

(72) Erfinder: **Gschwendtner, Jörg, Seitenstrasse 38, D-7300 Esslingen 1 (DE)**
Erfinder: **Löhlein, Wolfdieter, Goldregenstrasse 2, D-7033 Herrenberg 1 (DE)**

(74) Vertreter: **Gaugel, Heinz, Dipl.-Ing., Schönaicher Strasse 220, D-7030 Böblingen (DE)**

BUNDESDRUCKEREI BERLIN

Schaltungsanordnung zur Spannungspegelumsetzung und zugehöriges Verfahren

Die Erfindung bezieht sich auf eine Schaltungsanordnung mit Feldeffekttransistoren zur Spannungspegelumsetzung eines TTL-Eingangssignals in demgegenüber höhere FET-Pegel entsprechend dem Oberbegriff des Patentanspruchs 1. Als Anwendungsgebiet der Erfindung kommen in erster Linie integrierte Halbleiterspeicher-Bausteine für Datenverarbeitungsanlagen in Betracht.

Die in den heutigen Datenverarbeitungsanlagen eingesetzten integrierten Halbleiterspeicher sind überwiegend in FET-Technologie aufgebaut. Wegen ihrer höheren Schaltgeschwindigkeit werden im Rahmen einer solchen Datenverarbeitungsanlage jedoch auch an zahlreichen Stellen in Bipolartechnologie aufgebaute integrierte Schaltkreise eingesetzt, z. B. für schnelle Register, Logik usw. Selbstverständlich muß für die einwandfreie Funktion eines derart aus Bipolar- und Feldeffektbausteinen zusammengesetzten komplexen Schaltungsnetzes die Einhaltung der jeweils erforderlichen Betriebs- und insbesondere Ansteuerspannungspegel gewährleistet sein. Da die genannten FET-Speicherbausteine in typischen Fällen ihre Ansteuersignale von den Ausgängen von Bipolarbausteinen zugeführt bekommen, stellt sich an solchen Nahtstellen stets das Problem der zugehörigen Pegelanpassung.

Ein für Schaltkreiskonzepte mit Bipolartransistoren typisches Spannungspegelschema ist das sog. TTL-Pegelschema. Dabei ist beispielsweise vereinbart, daß der eine Binärzustand, z. B. die logische »0«, durch einen Spannungswert im Bereich von 0 bis 0,6 V und entsprechend der andere Binärzustand, z. B. die logische »1«, durch einen Spannungswert im Bereich von 2,4 bis zur Betriebsspannung von z. B. 5 V repräsentiert wird. Demgegenüber liegen die für FET-Schaltkreise typischen Ansteuer- und Betriebsspannungswerte deutlich höher. Daraus folgt aber, daß ein mit einem im ungünstigsten Fall lediglich 2,4 V betragenden Eingangssignal für den oberen Binärzustand angesteuerter Feldeffekttransistor mit einem typischen Schwellenspannungswert VT von etwa 1,5 V nur relativ schwach leiten würde. Mit anderen Worten, ein so angesteuerter Feldeffekttransistor würde auch in seinem Leitzustand noch relativ hochohmig sein und die von ihm verlangte Entladung eines weiteren Schaltungsknotens, einer Lastkapazität oder dergleichen nur vergleichsweise langsam durchführen können. Aus diesem Grunde wurden anfänglich an den Nahtstellen zwischen Bipolar- und FET-Bausteinen separate Pegelumsetzer-Bausteine in Bipolartechnologie vorgesehen, die hinsichtlich ihrer Ausgangsspannungen speziell auf die Eingangserfordernisse der FET-Bausteine zugeschnitten waren. Im Zuge der weiteren Entwicklung hat sich aber mehr und mehr die Forderung durchgesetzt, daß die FET-Speicherbausteine für sich an ihren äußeren Anschlüssen bereits voll TTL-kompatibel sind.

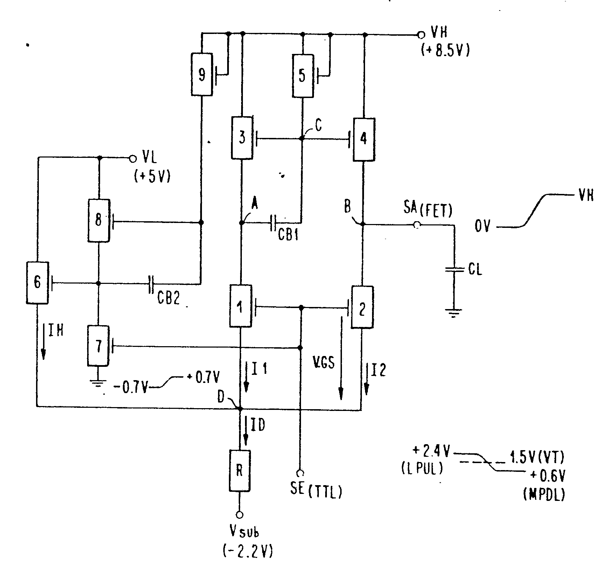

Es sind auch bereits mit Feldeffekttransistoren aufgebaute Eingangsschaltungen bekanntgeworden, die mit Eingangssignalen im TTL-Pegelschema betrieben werden können, vgl. die US-Patentschrift 3 739 194 sowie IEEE Journal of Solid-State Circuits, Vol. Sc-13, No. 3, Juni 1978, Seiten 333 bis 338, insbesondere Fig. 5 auf Seite 335. Bei den dort behandelten Schaltungen liegt die Situation vor, daß die Einsatzspannung (Schwellenspannung) des Eingangs-FET niedriger liegt als der dem Ausschaltzustand zugeordnete Spannungspegel des Eingangssignals. Ohne zusätzliche Maßnahmen wäre somit ein sicheres Ausschalten des Eingangs-FET durch ein TTL-Eingangssignal nicht zu gewährleisten. Es müßte vielmehr für die Herstellung der Feldeffekttranistoren auf einen geänderten Herstellungsprozeß übergegangen werden, durch den die Feldeffekttransistoren mit einer höheren Schwellenspannung ausgestattet würden (wenn man z. B. N-Kanal Anreicherungs-FET annimmt). In den vorgenannten Literaturstellen wird demgegenüber das sichere Ausschalten des Eingangs-FET dadurch ermöglicht, daß dessen Einschaltspannung durch Anlegen einer Vorspannung an die Source-Elektrode über den Ausschaltpegel angehoben wird. Diese Anhebung wirkt sich jedoch nachteilig für den Einschaltvorgang des Eingangs-FET aus, so daß in der zweiten der genannten Literaturstellen die besagte Anhebung während solcher Eingangssignalphasen rückgängig gemacht werden kann.

Bei der Erfindung wird eine demgegenüber verschiedene Ausgangssituation vorausgesetzt. Sie bezieht sich auf Eingangsschaltungen mit Feldeffekttransistoren, deren Schwellenspannungswert zwischen dem Einschalt- und Ausschaltpegel des TTL-Eingangssignals liegt, so daß von daher prinzipiell das Ein- und Ausschalten des Eingangs-FET möglich ist. Die Problematik, für eine eine Lösung gesucht wird, besteht dabei in dem eingangs bereits erwähnten Sachverhalt, daß ein mit einer so geringen Potentialdifferenz zur Schwellenspannung angesteuerter Feldeffekttransistor relativ lange Umschaltzeiten aufweist und zudem in seinem Leitzustand immer noch relativ hochohmig sein würde. Entsprechend langsam ginge die von einem derart angesteuerten Feldeffekttransistor verlangte Entladung eines weiteren Schaltungsknotens oder dergleichen vor sich.

In Anwendungsfällen, bei denen die Ansteuersignale volle FET-Pegel aufweisen, hat sich im Hinblick auf eine hohe Schaltgeschwindigkeit sowie hohe Ausgangsspannungspegel als sehr vorteilhaft eine mit Feldeffekttransistoren aufgebaute Schaltung erwiesen, wie sie z. B. in der DE-Offenlegungsschrift 2 243 671 der Anmelderin oder in der US-Patentschrift 3 710 271 angegeben ist. Es handelt sich dabei um eine verbesserte sog. Bootstrap-Treiberstufe, bei der der Bootstrap-Kondensator in einer parallel zur Ausgangsinverterstufe angeordneten unbelasteten gleichartigen Inverterstufe vorgesehen ist. Wünschenswert wäre es nun, eine Schaltung dieser Art auch als Eingangsschaltung, die mit relativ niedrigen Eingangssignalpegeln (entsprechend TTL-Eingangssignalen) ansteuerbar ist, zur entsprechenden Spannungspegelumsetzung in demgegenüber höhere (FET-)Pegel einsetzen zu können.

In allgemeinerer Hinsicht liegt der Erfindung somit die Aufgabe zugrunde, derartige mit Feldeffekttransistoren aufgebaute Eingangsschaltungen hinsichtlich ihrer Kompatibilität für relativ kleine Eingangssignale, z. B. für TTL-Signale, zu verbessern. Die Erfindung, wie sie in den Patentansprüchen gekennzeichnet ist, gibt Maßnahmen zur Erweiterung einer an sich bekannten FET-Schaltungsanordnung an, um auch bei einer Ansteuerung mit (gegenüber FET-Pegeln) relativ niedrigen Signalpegeln verbesserte Treibereigenschaften, insbesondere eine hohe Schaltgeschwindigkeit, zu erreichen, ohne eine flächenmäßige Vergrößerung der Eingangstransistoren dafür in Kauf nehmen zu müssen. Zusammengefaßt wird nach der Erfindung die zwischen Gate und Source der Eingangstransistoren sowohl im Leit- als auch Sperrzustand jeweils wirksame Potentialdifferenz relativ zum jeweiligen Potential des Eingangssignals in der Weise erhöht, daß an der Source des oder der Eingangstransistoren eine relativ zum jeweiligen Gate gegensinnige Potentialänderung über einen in Abhängigkeit vom Eingangssignal steuerbaren Hilfsstromkreis in einer noch näher zu erläuternden Weise eingestellt wird. In allgemeinerer Form wird dabei von einem Stromübernahmeprinzip Gebrauch gemacht, bei dem der in einem Schaltzustand fließende Strom im anderen Schaltzustand jeweils auf einen dazu benachbart angeordneten Hilfsstromzweig umgeschaltet wird, wobei lediglich ein relativ geringer zusätzlicher Hilfsstrom zur gegensinnigen Potentialverschiebung und damit zur Erhöhung der wirksamen Potentialdifferenz zwischen Gate und Source des Eingangs-FET hinzukommt. Damit läßt sich auch bei einer Ansteuerung der Eingangs-FET mit einem gegenüber FET-Pegeln geringen Signalhub eine erheblich verbesserte Schaltgeschwindigkeit erzielen, ohne daß die Eingangs-FET erheblich größer dimensioniert werden müßten, was bisher unumgänglich war.

Die Erfindung wird im folgenden anhand des in der Zeichnung dargestellten und lediglich einen Ausführungsweg darstellenden Ausführungsbeispiels näher erläutert. Für die Transistoren sind in diesem Fall übliche N-Kanal MOS-Feldeffekttransistoren vom Anreicherungstyp vorausgesetzt, deren Betriebsspannung VH typisch etwa +8,5 V beträgt und deren Schwellenspannungswert bei etwa 1,5 V liegen möge. Die Erfindung kann jedoch in gleicher Weise auch mit Feldeffekttransistoren anderer Art, z. B. des anderen Leitungstyps bei entsprechend geänderter Betriebsspannungspolarität, realisiert werden.

Wie bereits eingangs erwähnt wurde, handelt es sich bei dem in der Figur enthaltenen Schaltungsteil mit den Feldeffekttransistoren 1 bis 5 um einen an sich bekannten Schaltkreis. In der bekannten Version ist der mit D bezeichnete Schaltungsknoten an ein festes Potential (Massepotential) gelegt. Dieser Schaltkreis stellt eine sog. schnelle Bootstrap-Treiberstufe dar, bei der der Bootstrap-Kondensator CB1 in einer parallel zur Ausgangsinverterstufe (Transistoren 2 und 4) angeordneten unbelasteten gleichartigen Inverterstufe (Transistoren 1 und 3) vorgesehen ist. Die Gate-Elektroden der beiden Eingangs-FET 1 und 2 sind miteinander und mit dem Signaleingang SE verbunden. Der Signalausgang SA liegt am mit B bezeichneten Verbindungspunkt zwischen dem Eingangs-FET 2 und seinem Last-FET 4. Die am Ausgang wirksame Belastung ist durch CL angedeutet. Von besonderer Bedeutung bei diesem Schaltkreis ist, daß das Ausgangssignal den vollen Wert der Betriebsspannung VH dadurch erreicht, daß das Gate des FET 4 durch die Bootstrap-Anordnung von 1, 3, 5 und CB1 über den Wert VH angehoben wird. Auf weitere Einzelheiten hinsichtlich des Aufbaus und der Betriebsweise dieses Schaltkreises kann an dieser Stelle verzichtet werden, da es sich insoweit um einen bekannten Schaltkreis handelt. Ergänzend wird deshalb ausdrücklich auf die eingangs genannten Literaturstellen (DE-Offenlegungsschrift 2 243 671, US-Patentschrift 3 710 271) verwiesen.

Will man den bisher beschriebenen Schaltkreis am Signaleingang SE statt mit vollen FET-Pegeln mit demgegenüber geringeren Signalpegeln, wie sie z. B. für TTL-Schaltungskonzepte typisch sind, ansteuern, d. h. einen solchen Schaltkreis als TTL-FET-Pegelumsetzer in FET-Bausteinen einsetzen, stehen dem die folgenden Nachteile entgegen. In diesem Fall ist nämlich die zwischen Gate und Source der Eingangstransistoren 1 und 2 wirksame Spannung $(V_{GS} - V_T)$ sehr gering. In der Zeichnung sind die für ein TTL-Signal zu berücksichtigenden typischen Unter- bzw. Obergrenzen für die beiden Signalpegel mit LPUL = 2,4 V bzw. MPDL = 0,6 V zusammen mit einer Schwellenwertspannung $V_T = 1,5$ V illustriert. Wegen der bei derartig geringen Eingangssignalpegeln nur geringen Über- bzw. Unterschreitung der Schwellenspannung müssen zur Erzielung vernünftiger Treibereigenschaften, insbesondere im Hinblick auf einigermaßen kurze Schaltverzögerungen, die Eingangstransistoren 1 und 2 flächenmäßig entsprechend groß dimensioniert werden. Das aber bedeutet unmittelbar eine Erhöhung der parasitären Kapazitäten und damit einen Verlust an Schaltgeschwindigkeit.

Zur Lösung der obengenannten Problematik ist im Rahmen der Erfindung die im folgenden beschriebene Erweiterung des eingangs genannten Schaltkreises vorgesehen. Statt, wie bisher, den Source-Verbindungspunkt D der Eingangstransistoren 1 und 2 an ein festes Potential, z. B. Massepotential, zu legen, wird D nunmehr über ein Widerstandsbauelement R an eine in diesem Fall negative Spannungsquelle Vsub gelegt. R wird dabei vorteilhafterweise als mit den übrigen Schaltungselementen integrierbarer diffundierter Widerstand ausgebildet. Bei Vsub handelt es sich um eine potentialmäßig unter dem Ausschaltpegel des Eingangssignals liegende Spannungsquelle, die vorzugsweise durch die für die verwendeten Feldeffekttransistoren ohnehin vorzusehende Substratspannungsquelle gebildet wird. Der Source-Verbindungspunkt D ist ferner über einen FET 6 mit einer Spannungsquelle VL verbunden, wodurch ein Hilfsstromzweig für einen in den Knoten D fließenden Hilfsstrom IH gebildet wird. Statt einer Spannungsquelle VL mit gegenüber VH geringerer Spannung kann der Transistor 6 auch an VH gelegt werden. Durch die Wahl einer Hilfsspannungsquelle VL geringerer Spannung wird allerdings eine Verringerung der Verlustleistung ermöglicht.

Die Gate-Elektrode des Transistors 6 ist mit dem Ausgang einer Bootstrap-Inverterstufe mit den Transistoren 7, 8 und 9 sowie der Bootstrap-Kapazität CB2 verbunden. Dabei handelt es sich um eine für sich als konventionell anzusehende Teilschaltung. Die Gate-Elektrode des Transistors 7 ist mit den Gate-Elektroden der Transistoren 1 und 2 gemeinsam an den Schaltungseingang SE für das TTL-Eingangssignal angeschlossen.

Für die Erläuterung der Betriebsweise der Gesamtschaltung soll angenommen werden, daß es sich bei dem TTL-Eingangssignal um ein Selektionssignal handelt, wobei im unselektierten Zustand der Eingang SE den oberen Signalpegel aufweist und die Eingangstransistoren 1 und 2 leitend sind. Dadurch wird der Ausgang SA auf dem unteren Spannungspegel gehalten. Die Schaltung wird dabei so dimensioniert, daß im unselektierten Zustand der Source-Verbindungspunkt D auf einem negativen Potential von beispielsweise −0,7 V liegt. Dadurch liegt bezüglich der Eingangstransistoren 1 und 2 eine höhere wirksame Gate-Source-Spannung vor, als wenn nur das TTL-Eingangssignal an den Gate-Elektroden läge und der Source-Verbindungspunkt D Massepotential aufwiese. Wegen der höheren wirksamen Ansteuerspannung können die Eingangstransistoren 1 und 2 folglich beträchtlich kleiner als bisher dimensioniert werden. Transistor 7 ist in diesem Zeitabschnitt leitend und zieht das Potential an der Gate-Elektrode des Transistors 6 herunter, so daß Transistor 6 gesperrt ist. Der vom Source-Verbindungspunkt D über R zur Spannungsquelle Vsub fließende Strom ID wird demzufolge durch die Summe der Ströme I1 und I2 durch die Eingangstransistoren 1 und 2 gebildet, da wegen des gesperrten Transistors 6 kein Hilfsstrom IH fließen kann.

Beim Übergang in den selektierten Zustand geht das Eingangssignal in den unteren Spannungspegel über. In diesem Fall sperrt sogleich Transistor 7, wodurch (unterstützt durch den Bootstrap-Vorgang) das Potential am Gate von Transistor 6 rasch angehoben wird. Durch den nun leitenden Transistor 6 kann ein Hilfsstrom IH in den Source-Verbindungspunkt D fließen, wodurch dessen Potential ansteigt, beispielsweise auf +0,7 V. Durch das gleichzeitige Absinken des Gate-Potentials der Eingangstransistoren 1 und 2 werden diese außerordentlich schnell abgeschaltet. Als Folge davon läuft das Potential des Schaltungsknotens A sehr schnell in Richtung auf die Betriebsspannung VH hoch, was sofort den Knoten C über VH hinaus ansteigen läßt (Bootstrap-Vorgang). Durch den schnellen Umschaltvorgang wird weiterhin ein unerwünschter Überlappungsstrom im Transistor 2 beim Ansteigen des Potentials am Ausgangsknoten B verhindert. Das im eingeschwungenen Zustand auf etwa +0,7 V angestiegene Potential am Knoten D leistet eine sichere Sperrung der Transistoren 1 und 2 im selektierten Zustand. Hinsichtlich der Ströme gilt nunmehr, daß ID durch IH gebildet wird und etwas größer ist als die Summe von I1 und I2 im unselektierten Zustand.

Beim erneuten Umschalten in den selektierten Zustand, d. h. wenn der Eingang wieder vom unteren in den oberen Signalpegel übergeht, wird über den Feldeffekttransistor 7 das Gate des FET 6 entladen. Der zusätzliche Strom IH in den Source-Verbindungspunkt vermindert sich, was ein Absinken der Spannung an D bedeutet. Dadurch werden die Eingangstransistoren 1 und 2 außerordentlich schnell eingeschaltet, wodurch eine am Ausgang wirksame Last CL entsprechend schnell entladen werden kann.

Durch die an dem bekannten Schaltkreis vorgenommenen Maßnahmen steht somit eine mit Feldeffekttransistoren aufgebaute Pegelumsetzschaltung von TTL-Pegeln in FET-Pegel mit erheblich verbesserten Eigenschaften zur Verfügung. Es hat sich gezeigt, daß damit bei vergleichbaren Lastbedingungen eine auf die Hälfte reduzierte Schaltverzögerungszeit erzielbar ist. Dabei ist festzuhalten, daß die zugrunde liegenden Maßnahmen nicht notwendig auf eine Bootstrap-Treiberstufe der im Ausführungsbeispiel vorausgesetzten Art beschränkt ist. Maßgeblich ist vielmehr der in der geschilderten Weise gegensinnig zum Eingangssignal ausgeführte Source-Potentialverlauf. Die Potentialabsenkung bzw. -anhebung erfolgt dabei durch die Stromübernahme von dem (den) Eingangstransistor(en) auf einen mit dem Source-Verbindungspunkt gekoppelten Hilfsstromzweig. Durch den Einsatz des Stromübernahmeprinzips verringern sich überdies die durch stark unterschiedliche Belastung ansonsten störenden Spannungsschwankungen auf den Versorgungsleitungen.

Die mit der Erfindung erzielbaren Vorteile bestehen im wesentlichen darin, daß die Eingangs-FET 1 und 2 wesentlich kleiner dimensioniert werden können, was neben einer Flächenersparnis in der integrierten Ausführung auch zu geringeren parasitären Kapazitäten führt, die sich ansonsten nachteilig auf die Schaltgeschwindigkeit auswirken würden. Durch die Mitkopplung über den Source-Verbindungspunkt D werden die Anstiegs-/Abfallzeiten des Eingangssignals außerdem verstärkt und dadurch die Schaltverzögerung beträchtlich verringert. Durch die Erhöhung der wirksamen Steuerspannung wird zudem die Störempfindlichkeit einer solchen Umsetzschaltung wesentlich verringert. Kann man schließlich in bestimmten Fällen auf die mögliche Geschwindigkeitsverbesserung verzichten, läßt sich statt dessen bei gleicher Schaltverzögerung wie bei der bekannten Schaltung mit den angegebenen Maßnahmen eine Pegelumsetzerschaltung mit demgegenüber geringerer Verlustleistung dimensionieren.

**Patentansprüche**

1. Schaltungsanordnung mit Feldeffekttransistoren zur Spannungspegelumsetzung eines (TTL-)Eingangssignals in demgegenüber höhere FET-Pegel enthaltend eine Parallelschaltung zweier Treiberstufen aus je einem Eingangstransistor (1, 2) und einem in Reihe dazu liegenden Lasttransistor (3, 4), wobei die beiden Eingangstransistoren (1, 2) hinsichtlich ihrer Gate-Elektroden zum gemeinsamen Schaltungseingang (SE) und hinsichtlich ihrer Source-Elektroden zu einem Source-Verbindungspunkt (D) zusammengefaßt sind, wobei ferner die beiden Lasttransistoren (3, 4) mit ihren Gate-Elektroden zu einem Verbindungspunkt (C) geführt sind, der über eine Bootstrap-Rückkopplung (CB1, 5) mit dem Verbindungspunkt (A) des Eingangs- und Lasttransistors der zur ausgangsseitigen Treiberstufe (2, 4) parallelen Treiberstufe (1, 3) verbunden ist, und wobei am Verbindungspunkt (B) zwischen Eingangs- und Lasttransistoren der ausgangsseitigen Treiberstufe (2, 4) der Schaltungsausgang (SA) vorgesehen ist, dadurch gekennzeichnet, daß mit dem Source-Verbindungspunkt (D) der Eingangstransistoren (1, 2) ein in Abhängigkeit vom (TTL-)Eingangssignal schaltbarer, ein Widerstandsbauelement (R) enthaltender Hilfsstromzweig (6, R) verbunden ist, der einen solchen zusätzlichen Hilfsstrom (IH) an den Source-Verbindungspunkt (D) liefert, daß infolge des am Widerstandsbauelement (R) auftretenden Spannungsabfalls am Source-Verbindungspunkt (D) der Eingangstransistoren (1, 2) eine relativ zur Gate-Elektrode gegensinnige Potentialänderung hervorgerufen wird.

2. Schaltungsanordnung nach Anspruch 1, dadurch gekennzeichnet, daß der Source-Verbindungspunkt (D) der Eingangstransistoren (1, 2) über das Widerstandsbauelement (R) mit dem Anschluß einer Spannungsquelle (Vsub) verbunden ist, deren Potential unter dem Ausschaltpegel des Eingangssignals liegt und vorzugsweise gleichzeitig die Substratvorspannungsquelle für die verwendeten Feldeffekttransistoren darstellt.

3. Schaltungsanordnung nach Anspruch 2, dadurch gekennzeichnet, daß das Widerstandsbauelement (R) ein Halbleiterwiderstand ist.

4. Schaltungsanordnung nach einem der vorhergehenden Ansprüche, gekennzeichnet durch einen mit seiner Source-Drain-Strecke zwischen dem Source-Verbindungspunkt (D) der Eingangstransistoren (1, 2) und einer Spannungsquelle (VL) mit einem über dem Einschaltpegel liegenden Potential angeordneten, Teil des Hilfsstromkreises (6, R) bildenden Feldeffekttransistor (6), an dessen Gate-Elektrode ein gegenüber dem (TTL-)Eingangssignal gegenphasiges Steuersignal anliegt.

5. Schaltungsanordnung nach Anspruch 4, dadurch gekennzeichnet, daß die Gate-Elektrode des mit dem Source-Verbindungspunkt (D) verbundenen Feldeffekttransistors (6) mit dem Ausgang einer, vorzugsweise als Bootstrap-Stufe ausgeführten, Inverterstufe (7, 8, 9) verbunden ist, deren Eingangstransistor (7) vom (TTL-)Eingangssignal angesteuert wird.

6. Schaltungsanordnung nach einem der vorhergehenden Ansprüche, dadurch gekennzeichnet, daß der Hilfsstromzweig (6, R) derart ausgeführt ist, daß der über ihn im eingeschalteten Zustand an den Source-Verbindungspunkt (D) gelieferte Strom (IH) etwas größer ist als der Strom, der bei eingeschalteten Eingangstransistoren (1, 2) an den Source-Verbindungspunkt (D) geliefert wird.

7. Schaltungsanordnung nach einem der vorhergehenden Ansprüche, dadurch gekennzeichnet, daß die Spannungsquelle (VL) für den Hilfsstromkreis (6, R) einen geringeren Spannungswert als die Versorgungsspannungsquelle (VH) für die Treiberstufen-Transistoren (1 bis 5, 9) aufweist.

8. Verfahren zur Spannungspegelumsetzung eines (TTL-)Eingangssignals in demgegenüber höhere FET-Pegel unter Einsatz einer Schaltungsanordnung nach einem der vorhergehenden Ansprüche, dadurch gekennzeichnet, daß die zwischen Gate und Source der Eingangstransistoren (1, 2) wirksame Potentialdifferenz relativ zur Potentialdifferenz aufgrund des (TTL-)Eingangssignals am Gate beim Einschalten der Eingangstransistoren erhöht und beim Abschalten vermindert wird, indem über eine Mitkopplung am Source-Verbindungspunkt (D) der Eingangstransistoren eine relativ zum jeweiligen Gate gegensinnige Potentialänderung eingestellt wird.

9. Verfahren nach Anspruch 8, dadurch gekennzeichnet, daß der im Leitzustand der Eingangstransistoren (1, 2) in den Source-Verbindungspunkt (D) fließende Strom beim Ausschalten von einem mit dem Source-Verbindungspunkt verbundenen Hilfsstromkreis übernommen wird, wobei je nach der gewählten Vergrößerung des am Cource-Verbindungspunkt (D) zur Auswirkung kommenden Spannungsabfalls (an R) und damit der jeweiligen Erhöhung der zwischen Gate und Source wirksamen Potentialdifferenz ein entsprechend größerer Hilfsstrom (IH) im Hilfsstromkreis veranlaßt wird.

## Claims

1. A circuit arrangement with field-effect transistors for converting the voltage levels of a (TTL) input signal into higher FET levels, comprising a parallel connection of two driver stages each provided with one input transistor (1, 2) and one load transistor (3, 4) serially connected thereto, wherein the two input transistors (1, 2) have their gate electrodes connected to a common circuit input (SE) and their source electrodes to a source bias node (D), wherein furthermore the two load transistors (3, 4) have their gate electrodes connected to a node (C) which, through a bootstrap feedback (CB1, 5), is connected to the node (A) of the input and load transistor of the driver stage (1, 3) connected in parallel to the output side driver stage (2, 4), and wherein the circuit output (SA) is provided at the node (B) between the input and load transistor of the output side driver stage (2, 4), characterized in that the source bias node (D) of the input transistors (1, 2) has connected to it an auxiliary current circuit (6, R) switchable as a function of the (TTL) input signal and comprising a resistive element (R), said auxiliary current circuit supplying an additional auxiliary current (IH) to the source bias node (D) such that as a result of the voltage drop occurring at the resistive element (R) a potential shift opposite to the gate electrode potential is produced at the source bias node (D) of the input transistors (1, 2).

2. The circuit arrangement according to claim 1, characterized in that the source bias node (D) of the input transistors (1, 2) is connected through the resistive element (R) to the terminal of a voltage source (Vsub), whose potential is below the switch-off level of the input signal and which preferably simultaneously constitutes the substrate bias source for the field-effect transistors used.

3. The circuit arrangement according to claim 2, characterized in that the resistive element (R) is a semiconductor resistor.

4. A circuit arrangement according to any one of the preceding claims, characterized by a field-effect transistor (6), forming part of the auxiliary current circuit (6, R), the source-drain path of which is positioned between the source bias node (D) of the input transistors (1, 2) and a voltage source (VL) with a potential above the switch-on level, and to the gate electrode of which a control signal, out-of-phase with the (TTL) input signal, is applied.

5. The circuit arrangement according to claim 4, characterized in that the gate electrode of the field-effect transistor (6), connected to the source bias node (D), is linked to the output of an inverter stage (7, 8, 9), preferably designed as a bootstrap stage, the input transistor (7) of which is controlled in response to the (TTL) input signal.

6. A circuit arrangement according to any one of the preceding claims, characterized in that the auxiliary current circuit (6, R) is designed so that the current (IH) supplied in the switched on state to the source bias node (D) is slightly higher than the current supplied to said source bias node (D) when input transistors (1, 2) are switched on.

7. A circuit arrangement according to any one of the preceding claims, characterized in that the supply voltage source (VL) for the auxiliary current circuit (6, R) has a lower voltage value than the supply voltage source (VH) for the driver stage transistors (1 to 5, 9).

8. A method of voltage level converting a (TTL) input signal into higher FET levels, using a circuit arrangement according to any one of the preceding claims, characterized in that the potential difference effective between gate and source of the input transistor (1, 2) relative to the potential difference occurring in response to the (TTL) input signal at the gate is increased when the input transistors are switched on and decreased when they are switchend off, by providing a potential shift directed oppositely to the respective gate potential, using a positive feedback at the source bias node (D) of the input transistors.

9. The method according to claim 8, characterized in that the current flowing into the source bias node (D) when the input transistors (1, 2) are conductive is taken over by an auxiliary current circuit, connected to the source bias node, when said input transistors are switched off, wherein, depending upon the selected increase of the voltage drop (at R), effective at the source bias node (D), and thus upon the respective increase of the potential difference, effective between gate and source, a correspondingly higher auxiliary current (IH) is produced in the auxiliary current circuit.

## Revendications

1. Circuit à transistors à effet de champ permettant de convertir le niveau de tension d'un signal d'entrée (TTL) aux niveaux de tension plus élevés des transistors à effet de champ, du genre comportant une connexion parallèle de deux étages d'attaque, chacun de ces deux étages étant constitué d'une part d'un transistor d'entrée (1, 2) et d'autre part d'un transistor de charge (3, 4) montés en série par rapport audit transistor d'entrée, les deux transistors d'entrée (1, 2) étant reliés, en ce qui concerne leurs électrodes de porte, à une entrée de circuit commune (SE), et en ce qui concerne leurs électrodes de source, à un point de connexion de source (D), et, en outre, les deux transistors de charge (3, 4) étant reliés, via leurs électrodes de porte à un point de connexion (C), lequel est relié par l'intermédiaire d'un circuit amplificateur à contreréaction (CB1, 5) à un point de connexion (A) du transistor d'entrée et du transistor de charge de l'étage d'attaque (1, 3) parallèle à l'étage d'attaque côté sortie (2, 4), et, la sortie du circuit s'effectuant au point de connexion (B) situé entre d'une part le transistor d'entrée et d'autre part le transistor de sortie (2, 4) de l'étage d'attaque du côté sortie, caractérisé en ce que le point de connexion de la source (D) des transistors d'entrée (1, 2) est relié à un circuit de courant auxiliaire (6, R) qui peut être commuté en fonction du signal d'entrée (TTL) et qui comporte une résistance (R), ledit circuit de courant auxiliaire alimentant le point de connexion de la source (D) en courant auxiliaire (IH), de telle sorte que la chute de tension qui se produit dans la résistance (R) provoque, au point de connexion de la source (D) des transistors d'entrée (1, 2), un décalage de potentiel opposé au potentiel de l'électrode de porte.

2. Circuit selon la revendication 1, caractérisé en ce que le point de connexion de source (D) des transistors d'entrée (1, 2) est relié, via la résistance (R), à la borne d'une source de tension (Vsub), dont le potentiel est inférieur au niveau bloqué du signal d'entrée et, parallèlement, constitue de préférence la source de polarisation de substrat des transistors à effet de champ utilisés dans ce système.

3. Circuit selon la revendication 2, caractérisé en ce que la résistance (R) est une résistance à semi-conducteur.

4. Circuit selon une des revendications précédentes, caractérisé en ce qu'il comporte un transistor à effet de champ (6) qui constitue une partie du circuit de courant auxiliaire (6, R), le trajet source-drain de ce transistor étant situé entre le point de connexion de la source (D) des transistors d'entrée (1, 2) et la borne de source de la tension (VL) dont le potentiel est supérieur au niveau de conduction, et l'électrode de porte de ce transistor recevant un signal de commande de phase opposée au signal d'entrée (TTL).

5. Circuit selon la revendication 4, caractérisé en ce que l'électrode de porte du transistor à effet de champ (6) relié au point de connexion de la source (D), est reliée à la sortie de l'un des étages d'inversion (7, 8, 9) réalisé de préférence en tant qu'étage d'amplification à contre-réaction, dont le transistor d'entrée (7) est commandé par le signal d'entrée (TTL).

6. Circuit selon l'une des revendications précédentes, caractérisé en ce que le circuit de courant auxiliaire (6, R) est réalisé de sorte que le courant (IH) qu'il fournit, lorsqu'il est passant, au point de connexion de la source (D) est plus élevé que le courant qui alimente le point de connexion de la source (D) lorsque les transistors d'entrée (1, 2) sont conducteurs.

7. Circuit selon l'une des revendications précédentes, caractérisé en ce que la valeur de la tension (VL) qui est fournie au circuit de courant auxiliaire (6, R) est plus faible que celle de la source de polarisation (VH) fournie aux transistors (1 à 5, 9) des étages d'attaque.

8. Procédé pour convertir le niveau de tension d'un signal d'entrée (TTL) en niveaux de tension FET plus élevés au moyen d'un des circuits décrits dans l'une des revendications précédentes, caractérisé en ce que la différence de potentiel effective entre la porte et la source des transistors d'entrée (1, 2) est, par rapport à la différence de potentiel résultant du signal d'entrée (TTL) transmis à la porte, accrue lorsque les transistors d'entrée sont conducteurs, et diminuée lorsqu'ils sont bloqués, et ce, en fournissant un décalage de potentiel directement opposé au potentiel de porte correspondante et obtenu par réaction au point de connexion de la source (D) des transistors d'entrée.

9. Procédé selon la revendication 8, caractérisé en ce que le courant qui est fourni au point de connexion de la source (D) lorsque les transistors d'entrée (1, 2) sont conducteurs, est capté lorsque ceux-ci sont bloqués, par un circuit de courant auxiliaire relié audit point de connexion de la source, ce qui entraîne une injection de courant auxiliaire (IH) dans le circuit de courant auxiliaire qui est plus ou moins importante en fonction, d'une part, de la grandeur choisie de la chute de tension qui apparaît au point de connexion de la source (D), et, d'autre part, de l'augmentation correspondante de la différence de potentiel réelle entre la porte et la source.